# EUROPÄISCHE PATENTSCHRIFT

(11) **EP 2 976 931 B1**
(45) Veröffentlichungstag und Bekanntmachung des Hinweises auf die Patenterteilung: **30.09.2020**
(21) Anmeldenummer: 14713403.5
(22) Anmeldetag: 17.03.2014
(51) Int. Cl.: H05K 7/14, H02B 1/20, H02G 5/00, H02M 7/00

(54) **STROMSCHIENENANORDNUNG UND VERFAHREN ZUR HERSTELLUNG EINER STROMSCHIENENANORDNUNG**
BUSBAR ARRANGEMENT AND METHOD FOR PRODUCING A BUSBAR ARRANGEMENT
ENSEMBLE BARRE CONDUCTRICE ET PROCÉDÉ DE FABRICATION D'UN ENSEMBLE BARRE CONDUCTRICE

(30) Priorität: 19.03.2013 DE 102013204825
(43) Veröffentlichungstag der Anmeldung: 27.01.2016
(73) Patentinhaber: Bombardier Transportation GmbH, 10785 Berlin (DE)
(72) Erfinder: SCHUPPLI, Rudolf, CH-5330 Bad Zurzach (CH); GERMANN, Markus, CH-5023 Biberstein (CH)
(74) Vertreter: Patentanwälte Bressel und Partner mbB
(86) Internationale Anmeldenummer: PCT/EP2014/055263
(87) Internationale Veröffentlichungsnummer: WO 2014/147011

(56) Entgegenhaltungen:
- EP-A2- 0 783 199
- EP-A2- 0 877 472
- DE-B1- 2 739 245
- US-A- 5 422 440
- US-A1- 2004 112 626

## Beschreibung

Die Erfindung betrifft eine Stromschienenanordnung sowie ein Verfahren zur Herstellung einer Stromschienenanordnung.

Stromschienenanordnungen werden unter anderem zur elektrischen Kontaktierung von Leistungshalbleiterbauelementen eingesetzt. So können z.B. als MOSFET oder IGBT ausgebildete Leistungshalbleiterbauelemente, die z.B. Teil eines Wechselrichters sein können, mittels einer Stromschienenanordnung elektrisch kontaktiert werden.

So beschreibt die EP 0 677 916 A2 eine Stromrichteranlage mit einer ersten DC-Schiene, einer zweiten DC-Schiene und mindestens einer AC-Schiene, wobei sich Isolierschichten zwischen diesen Schichten befinden.

Die WO 01/93392 A1 offenbart ein Verbindungssystem zweier Gleichstromsysteme, welches aus zwei Kupferschienen besteht, die jeweils mit einer Isolierschicht laminiert sind.

Die EP 0 998 019 A1 offenbart eine Halbleiter-Schaltungsanordnung mit einer Zwischenkreis-Leiterplatte zur elektrischen Kontaktierung von Zwischenkreis-Bauelementen wie z.B. Kondensatoren.

Die US 2004/0062004 A1 offenbart eine elektronische Wandleranordnung mit einer ersten, einer zweiten und einer dritten Verbindungsschiene, wobei jede Verbindungsschiene mit Anschlüssen von mindestens einem ersten und einem zweiten Paar von Leistungsschalterelementen verbunden sind, wobei das erste und das zweite Paar von Leistungsschalterelementen, die mit einer bestimmten Verbindungsschiene verbunden sind, von verschiedenen Leistungsschaltermodulen sind.
Es stellt sich das technische Problem, eine Stromschienenanordnung und ein Verfahren zur Herstellung einer Stromschienenanordnung zu schaffen, die zwischen den Leiterstrukturen der Stromschienenanordnung wirkenden Stromkräfte, insbesondere im Kurzschlussfall, minimieren.

Die US 5,422,440 A offenbart eine Stromschienenanordnung mit geringer Induktivität für industrielle Spannungslevel und für Leistungsanwendungen, wobei die

Stromschienenanordnung zwei oder mehrere längliche elektrisch leitende Schienen mit abgerundeten Kanten enthält. Streifen aus einem dielektrischen isolierenden Material sind zwischen zwei der länglichen elektrisch leitenden Schienen angeordnet.

Die EP 0 877 472 A2 offenbart ein Stromrichter-Modul mit Leistungshalbleiterschaltern und einem Verschienungssystem, umfassend einen Plusanschluss, einen Minusanschluss sowie einen schienenförmigen Phasenanschluss, welche unter Zwischenfügung von Isolationselementen aufeinander gestapelt und auf einer Grundplatte befestigt sind.

Die DE 27 39 245 B1 offenbart einen Hochleistungsstromrichter mit zwei Stromschienen,die in Form und Fläche im wesentlichen gleichen Querschnitt besitzen und die mit einer Breitseite elektrisch isoliert etwa parallel zueinander liegen oder aneinander befestigt sind, wobei auf beiden an diese Breitseite angrenzenden Schmalseiten einer Stromschiene jeweils eine Reihe von Stromrichterventilen elektrisch leitend befestigt ist, aufeinanderfolgende Stromrichterventile jeder Reihe etwa gleichen Abstand zueinander besitzen und jedes Stromrichterventil mit einem Anschluss auf der benachbarten Schmalseite der zweiten Stromschiene elektrisch leitend verbunden ist und aufeinanderfolgende Anschlüsse etwa im gleichen Abstand wie die Stromrichterventile zueinander liegen,

Die EP 0 783 199 A2 offenbart ein Verschienungssystem für eine Zwischenkreisverschienung eines Stromrichters, umfassend einen Plus- und einen Minusanschluss sowie mindestens einen Phazenanschluss, wobei der Plus- und der Minusanschluss aus einem gitterförmigen, mit Aussparungen versehenen Polblech bestehen, dass der oder jeder Phasenanschluss schienenförmig ausgebildet ist und dass die Polbleche und die schienenförmigen Phasenanschlüsse in der Reihenfolge Plusanschluss, Minusanschluss, Phasenanschluss/ Phasenanschlüsse oder Minusanschluss, Plusanschluss, Phasenanschluss/Phasenanschlüsse unter Zwischenfügung von Isolationselementen aufeinander gestapelt und auf einem Träger befestigt sind.

Die Lösung des technischen Problems ergibt sich durch die Gegenstände mit den Merkmalen der Ansprüche 1 und 6 Weitere vorteilhafte Ausgestaltungen der Erfindung ergeben sich aus den Unteransprüchen.

Es ist eine Grundidee der Erfindung, dass eine Stromschienenanordnung zwei Leiterstrukturen umfasst, die derart relativ zueinander angeordnet und ausgebildet sind, dass Stromkräfte, die von den Leiterstrukturen aufeinander ausgeübt werden, reduziert werden, wobei gleichzeitig eine gewünschte, insbesondere niedrige, Induktivität gewährleistet wird.

Vorgeschlagen wird eine Stromschienenanordnung. Die Stromschienenanordnung dient insbesondere zum Anschluss leistungselektronischer Halbleiterbauelemente, z.B. MOSFETs oder IGBTs. Diese Halbleiterbauelemente können z.B. Bestandteil eines Stromrichters sein, z.B. eines Leistungsstromrichters in einem Schienenfahrzeug. Hierbei kann der Leistungsstromrichter zur Einstellung eines Stromes/einer Spannung für eine elektrische Maschine zum Antrieb des Schienenfahrzeugs dienen.

Die Stromschienenanordnung umfasst eine erste Leiterstruktur und eine zweite Leiterstruktur, wobei die erste Leiterstruktur und die zweite Leiterstruktur nicht direkt oder unmittelbar elektrisch verbunden sind, insbesondere in einem unkontaktierten Zustand nicht verbunden sind. Dies bedeutet, dass ohne eine zusätzliche elektrische Verbindung der ersten und zweiten Leiterstruktur kein Stromfluss von der ersten zur zweiten Leiterstruktur und umgekehrt erfolgen kann. Die erste Leiterstruktur, die auch als erste Leiterschiene bezeichnet werden kann, kann z.B. als Zuleiter ausgebildet sein, die im Betrieb ein erstes elektrisches Potential aufweist. Z.B. kann die erste Leiterstruktur zur Kontaktierung eines Hochspannungsanschlusses eines Brückenzweiges eines Stromrichters dienen, wobei der Brückenzweig zwei Leistungshalbleiterelemente umfasst. Die zweite Leiterstruktur, die auch als zweite Leiterschiene bezeichnet werden kann, kann z.B. als Rückleiter ausgebildet sein, die im Betrieb ein zweites elektrisches Potential aufweist, welches von dem ersten Potential verschieden, insbesondere kleiner, ist. Z.B. kann die zweite Leiterstruktur zur Kontaktierung eines Niederspannungsanschlusses des Brückenzweigs des Stromrichters dienen.

Weiter ist die erste Leiterstruktur wannenförmig ausgebildet. Hierbei kann die erste Leiterstruktur z.B. eine bodenseitige Leiterplatte und zwei seitliche Leiterplatten umfassen, die Seitenwände der wannenförmigen Leiterstruktur ausbilden. Die erste Leiterstruktur kann hierbei ein Innenvolumen umfassen. Beispielsweise kann das Innenvolumen von der Bodenleiterplatte und den seitlichen Leiterplatten umfasst werden. Vorzugsweise weist die erste Leiterstruktur ein U-förmiges Profil auf. Hierbei ist das Innenvolumen zu einer Seite der ersten Leiterstruktur hin geöffnet und somit von dieser Seite aus zugänglich.

Weiter ist auch die zweite Leiterstruktur wannenförmig ausgebildet. Zur Ausbildung der zweiten Leiterstruktur gelten die Ausführungen zur Ausbildung der ersten Leiterstruktur entsprechend.

Weiter ist zumindest ein Abschnitt der zweiten Leiterstruktur in einem Innenvolumen der ersten Leiterstruktur angeordnet. Beispielsweise kann der zumindest eine Abschnitt der zweiten Leiterstruktur von der offenen Seite des Innenvolumens der ersten Leiterstruktur her in das Innenvolumen der ersten Leiterstruktur hineinragen. Hierbei ist der zumindest eine Abschnitt der zweiten Leiterstruktur beabstandet von der ersten Leiterstruktur angeordnet. Insbesondere ist ein minimaler Abstand zwischen der ersten und der zweiten Leiterstruktur größer als ein vorbestimmter Abstand. Dies bedeutet, dass an jedem Punkt der ersten Leiterstruktur der geringste Abstand zu der zweiten Leiterstruktur größer als der vorbestimmte Abstand ist.

Der vorbestimmte Abstand kann insbesondere in Abhängigkeit einer gewünschten oder erforderlichen und vorbestimmten Luftstrecke und/oder Kriechstrecke, insbesondere einer Mindestluftstrecke und/oder Mindestkriechstrecke, gewählt werden. Beispielsweise kann eine erforderliche Luftstrecke und/oder Kriechstrecke 18 mm betragen. In diesem Fall kann der minimale Abstand größer als 18 mm sein. Insbesondere kann jedoch der minimale Abstand größer als eine Summe der erforderlichen Luftstrecke und/oder Kriechstrecke und einem Sicherheitsabstand, beispielsweise von 1 mm, sein.

Somit sind die erste Leiterstruktur und die zweite Leiterstruktur derart ausgebildet und relativ zueinander angeordnet, dass eine erste Stromkraft, die von zumindest einem Abschnitt der ersten Leiterstruktur auf die zweite Leiterstruktur ausgeübt wird, durch eine zweite Stromkraft, die von zumindest einem Abschnitt der zweiten Leiterstruktur auf die erste Leiterstruktur ausgeübt wird, zumindest teilweise kompensiert wird. Die Stromkraft wirkt hierbei auf die entsprechenden Leiterstrukturen. Die Stromkraft wird hierbei zumindest teilweise durch die Lorentzkraft gebildet, die bei Stromfluss durch die entsprechenden Leiterstrukturen auf diese Leiterstrukturen wirken.

Kompensieren bedeutet hierbei, dass eine bei Stromfluss auf die erste und die zweite Leiterstruktur wirkende resultierende Kraft kleiner als eine vorbestimmte Kraft, vorzugsweise Null, ist. Z.B. kann mindestens ein Anteil der von der ersten Leiterstruktur auf die zweite Leiterstruktur ausgeübten Stromkraft durch einen entgegengesetzt orientierten, jedoch gleich hohen, Anteil der von der zweiten Leiterstruktur auf die erste Leiterstruktur ausgeübten Stromkraft kompensiert werden. Die Stromkraft kann hierbei in Bezug auf die Leiterstrukturen abschnittsweise wirken.

Die erste Leiterstruktur kann hierbei einen ersten Anschluss, der auch als Eingangsanschluss bezeichnet werden kann, und einen zweiten Anschluss, der auch als Ausgangsanschluss bezeichnet werden kann, aufweisen. Der erste und der zweite Anschluss sind hierbei derart ausgebildet, dass die erste Leiterstruktur über den ersten bzw. zweiten Anschluss elektrisch kontaktierbar ist.

Ebenso kann die zweite Leiterstruktur einen ersten Anschluss, der auch als Eingangsanschluss bezeichnet werden kann, und einen zweiten Anschluss, der auch als Ausgangsanschluss bezeichnet werden kann, aufweisen.

Die erste und die zweite Leiterstruktur sind hierbei vorzugsweise einteilig ausgebildet.

Hierbei kann zwischen dem Ausgangsanschluss der ersten Leiterstruktur und dem Eingangsanschluss der zweiten Leiterstruktur mindestens ein elektrisches Bauelement, z.B. ein elektrischer Verbraucher, insbesondere aber auch mindestens ein Brückenzweig eines Stromrichters, angeordnet sein, wobei der Brückenzweig beispielsweise zwei leistungselektronische Schaltelemente umfassen kann. In diesem kontaktierten Zustand sind die erste Leiterstruktur und die zweite Leiterstruktur über das mindestens eine elektrische Bauelement elektrisch verbunden.

Hierdurch wird in vorteilhafter Weise eine Stromschienenanordnung geschaffen, die eine elektrische Kontaktierung von z.B. Verbrauchern oder insbesondere leistungselektronischen Bauelementen ermöglicht, wobei durch einen Stromfluss erzeugte Stromkräfte durch die physikalische Ausgestaltung und Anordnung zumindest teilweise kompensiert werden. Somit werden die auf die Leiterstrukturen wirkenden Kräfte während eines Stromflusses durch die Leiterstrukturen reduziert. Dies wiederum erhöht eine Betriebssicherheit sowie eine Lebensdauer der Leiterstrukturen.

Ebenfalls haben Simulationen gezeigt, dass die resultierenden Stromkräfte und eine Induktivität der vorgeschlagenen Stromschienenanordnung gering sind. Eine solche geringe Induktivität ist bei Betrieb der Stromschienenanordnung, insbesondere bei Stromfluss durch die Stromschienenanordnung, gewünscht.

Weiter können die erste und zweite Leiterstruktur derart ausgebildet und relativ zueinander angeordnet sein, dass die erste Stromkraft die zweite Stromkraft zumindest teilweise kompensiert, falls die erste Leiterstruktur und die zweite Leiterstruktur kurzgeschlossen sind. Alternativ oder kumulativ kann die erste Stromkraft die zweite Stromkraft zumindest teilweise kompensieren, wenn ein Stromfluss durch die erste Leiterstruktur und die zweite Leiterstruktur eine vorbestimmte Frequenz aufweist. Die erste Stromkraft bezeichnet hierbei eine von der ersten auf die zweite Leiterstruktur ausgeübte Stromkraft, wobei die zweite Stromkraft eine von der zweiten Leiterstruktur auf die erste Leiterstruktur ausgeübte Stromkraft bezeichnet.

Insbesondere im Kurzschlussfall können auf Stromschienen aufgrund der hohen Stromstärken sogenannte Kurzschluss-Stoßkräfte wirken, die zu einer Zerstörung der Stromschienenanordnung führen können. Diese Kurzschlussströme können hierbei, je nach Anwendungsfall, eine vorbestimmte Frequenz, z.B. 3 kHz, aufweisen.

Durch die vorgeschlagene Stromschienenanordnung wird also in besonders vorteilhafter Weise die Auswirkung der aufgrund hoher Stromstärken erzeugten hohen Stromkräfte kompensiert.

Weiter ist zwischen der ersten Leiterstruktur und der zweiten Leiterstruktur mindestens ein Abstandshalter angeordnet. Der Abstandshalter kann hierbei insbesondere aus einem elektrisch isolierenden Material ausgebildet sein. Auch können mehrere Abstandshalter, z.B. entlang einer Längsrichtung der Leiterstrukturen, zwischen der ersten Leiterstruktur und der zweiten Leiterstruktur angeordnet sein. Insbesondere kann der Abstandshalter in dem Innenvolumen der ersten Leiterstruktur und/oder im Innenvolumen der zweiten Leiterstruktur angeordnet sein.

Beispielsweise kann der Abstandshalter Ausnehmungen oder Nuten aufweisen, in die die ebenfalls im Innenvolumen angeordneten Abschnitte der seitlichen Leiterplatten der ersten Leiterstruktur bzw. der zweiten Leiterstruktur angeordnet werden können.

So kann z.B. ein erster Teil des Abstandshalters im Innenvolumen der ersten Leiterstruktur angeordnet sein, wobei dieser erste Teil eine zentrale Nut aufweist, die zu der Seite hin geöffnet ist, zu der auch das Innenvolumen der ersten Leiterstruktur geöffnet ist. In diese zentrale Nut kann der vorhergehend erläuterte Abschnitt der seitlichen Leiterplatte der zweiten Leiterstruktur eingebracht werden.

Entsprechend kann ein zweiter Teil des Abstandshalters im Innenvolumen der zweiten Leiterstruktur angeordnet sein. Dieser zweite Teil kann ebenfalls eine zentrale Nut aufweisen, wobei diese zentrale Nut zu einer Seite hin geöffnet ist, zu der auch das Innenvolumen der zweiten Leiterstruktur geöffnet ist. In dieser zentralen Nut des zweiten Teils kann der vorhergehend erläuterte Abschnitt der seitlichen Leiterplatte der ersten Leiterstruktur angeordnet sein. Somit kann der Abstandshalter einen im Wesentlichen s-förmigen Querschnitt aufweisen.

Es ist möglich, dass der erste Teil des Abstandshalters das Innenvolumen der ersten Leiterstruktur vollständig oder nur zu einem bestimmten Teil ausfüllt. Auch ist es möglich, dass der erste und/oder der zweite Teil des Abstandshalters derart ausgebildet und in den Innenvolumina angeordnet sind, dass im Bereich der Ecken der ersten und der zweiten Leiterstruktur Freiräume angeordnet sind. Dies erleichtert eine Einbringung des Abstandshalters in die Innenvolumina sowie zwischen die erste und die zweite Leiterstruktur, da hierdurch Fertigungstoleranzen der ersten und der zweiten Leiterstruktur kompensiert werden können.

Der Abstandshalter dient somit der Herstellung eines vorbestimmten Abstands des zumindest einen Abschnitts der seitlichen Leiterplatte der zweiten Leiterstruktur von den seitlichen Leiterplatten der ersten Leiterstruktur sowie von der Bodenleiterplatte der ersten Leiterstruktur. Entsprechend dient der zweite Teil des Abstandshalters der Herstellung eines vorbestimmten Abstandes des zumindest einen Abschnitts der seitlichen Leiterplatte der ersten Leiterstruktur von den seitlichen Leiterplatten der zweiten Leiterstruktur sowie von der Bodenleiterplatte der zweiten Leiterstruktur.

Hierdurch kann in vorteilhafter Weise erreicht werden, dass die vorhergehend erläuterten Luftstrecken und/oder Kriechstrecken eingehalten werden. Ebenfalls wird eine Fixierung der Anordnung der ersten Leiterstruktur relativ zu der zweiten Leiterstruktur sichergestellt.

Der Abstandshalter kann hierbei insbesondere als einstückiges oder einteiliges Bauteil ausgebildet sein. Somit sind der erste und der zweite Teil des Abstandshalters Bestandteile eines einstückig oder einteilig ausgebildeten Abstandshalters. Selbstverständlich kann jedoch der Abstandshalter auch mehrere Teile umfassen, die baulich getrennt voneinander ausgebildet sind.

Erfindungsgemäß weist die erste Leiterstruktur und/oder die zweite Leiterstruktur im Bereich des mindestens einen Abstandshalters zumindest eine Ausnehmung auf.

Die Ausnehmung kann hierbei im Bereich einer seitlichen Leiterplatte einer Leiterstruktur angeordnet sein, insbesondere im Bereich einer Seitenwand der seitlichen Leiterplatte. Alternativ oder kumulativ ist es möglich, dass eine Ausnehmung im Bereich einer Stirnseite einer seitlichen Leiterplatte einer Leiterstruktur angeordnet ist.

Die Ausnehmung bezeichnet hierbei eine Vertiefung, beispielsweise eine sacklochartige Vertiefung. Es ist jedoch auch möglich, dass die Ausnehmung als durchgehende Öffnung der entsprechenden Leiterplatte ausgebildet ist.

Hierdurch kann in vorteilhafter Weise sichergestellt werden, dass eine Schraube, die zur mechanischen Verbindung einer Leiterstruktur mit dem Abstandshalter genutzt wird, nicht in mechanischen Kontakt mit der jeweils anderen Leiterstruktur, in welcher die beschriebene Ausnehmung angeordnet ist, kommt. Hierdurch wird die Gefahr minimiert, dass eine elektrische Verbindung zwischen der ersten und der zweiten Leiterplatte über die Schraube erfolgt. Ebenfalls wird eine Durchschlagsfestigkeit erhöht, wenn ein vorbestimmter Mindestabstand zwischen einem Ende der Schraube und einer nicht durch die Schraube befestigten Leiterstruktur sichergestellt ist.

Hintergrund für die Ausbildung einer Ausnehmung ist, dass ein Bauraum der Stromschienenanordnung so gering wie möglich sein sollte, wobei jedoch die vorhergehend erläuterten Mindestluftstrecken und/oder Mindestkriechstrecken gewährleistet sein sollten. Gleichzeitig kann es erforderlich sein, dass die ebenfalls vorhergehend erläuterte mechanische Verbindung vorbestimmte Kräfte aufnehmen kann. Diese Anforderungen können bedingen, dass eine Länge der Schraube, die z.B. durch eine seitliche Leiterplatte der zweiten Leiterstruktur in ein Innengewinde des Abstandshalters eingebracht wird, der zwischen der seitlichen Leiterplatte der zweiten Leiterstruktur und einem Abschnitt der seitlichen Leiterplatte der ersten Leiterstruktur angeordnet ist, nur geringfügig kleiner oder gleich oder sogar größer als der Abstand zwischen der seitlichen Leiterplatte der zweiten Leiterstruktur und der seitlichen Leiterplatte der ersten Leiterstruktur ist. Durch die Ausnehmung kann hierbei vorteilhafterweise in dem Abschnitt, in welchem die Schraube angeordnet ist, der Abstand zwischen den seitlichen Leiterplatten der ersten und der zweiten Leiterstruktur erhöht werden, wodurch ein mechanischer und somit elektrischer Kontakt zwischen der ersten und der zweiten Leiterstruktur vermieden werden kann. Trotzdem wird gleichzeitig der gewünschte geringe Bauraum und die gewünschte mechanische Verbindungsfestigkeit gewährleistet.

In einer bevorzugten Ausführungsform umfasst die erste Leiterstruktur zwei parallel und mit einem vorbestimmten Abstand zueinander angeordnete seitliche Leiterplatten und eine Bodenleiterplatte. Hierbei sind die seitlichen Leiterplatten senkrecht zur Bodenleiterplatte angeordnet. Hierbei ist es möglich, dass an den Verbindungsstellen der seitlichen Leiterplatten und der Bodenleiterplatte gebildete Kanten abgerundet ausgeführt sind.

Die erste Leiterstruktur weist somit ein U-förmiges Profil oder einen U-förmigen Querschnitt auf.

Weiter umfasst die zweite Leiterstruktur ebenfalls zwei parallel und mit einem vorbestimmten Abstand zueinander angeordnete seitliche Leiterplatten und eine Bodenleiterplatte. Weiter sind die seitlichen Leiterplatten senkrecht zur Bodenleiterplatte angeordnet. Somit weist auch die zweite Leiterstruktur ein U-förmiges Profil oder einen U-förmigen Querschnitt auf.

Weiter ist zumindest ein Abschnitt einer seitlichen Leiterplatte der zweiten Leiterstruktur in einem Innenvolumen der ersten Leiterstruktur angeordnet. Das Innenvolumen wird hierbei von den seitlichen Leiterplatten und der Bodenleiterplatte der ersten Leiterstruktur umfasst. Hierbei kann ein Abstand des zumindest einen Abschnitts der seitlichen Leiterplatte der zweiten Leiterstruktur zu den seitlichen Leiterplatten der ersten Leiterstruktur gleich sein und insbesondere größer als der vorhergehend erläuterte vorbestimmte Abstand sein. Hierbei wird dieser Abstand senkrecht zu den seitlichen Leiterplatten der ersten Leiterstruktur gemessen.

Weiter kann ein Abstand des zumindest einen Abschnitts der seitlichen Leiterplatte der zweiten Leiterstruktur zur Bodenleiterplatte der ersten Leiterstruktur gleich den vorhergehend erläuterten Abständen und insbesondere größer als der vorhergehend erläuterte vorbestimmte Abstand sein. Hierbei wird der Abstand senkrecht zur Bodenleiterplatte gemessen.

Selbstverständlich sind die Leiterplatten der ersten Leiterstruktur elektrisch verbunden. Auch die Leiterplatten der zweiten Leiterstruktur sind miteinander elektrisch verbunden.

Insbesondere können die erste Leiterstruktur und die zweite Leiterstruktur gleichartig ausgebildet sein, insbesondere gleiche Abmessungen, z.B. eine gleiche Länge, eine gleiche Breite und eine gleiche Höhe, aufweisen. Die Länge kann beispielsweise 1250 mm, die Breite beispielsweise 50 mm und die Höhe beispielsweise 45 mm betragen.

Hierbei bezeichnet eine Länge eine Dimension in einer Längsrichtung, die entlang einer zentralen Längsachse der entsprechenden Leiterstruktur gemessen wird. Eine Breite bezeichnet hierbei eine Dimension, die in einer Querrichtung gemessen wird, wobei die seitlichen Leiterplatten einer Leiterstruktur in dieser Querrichtung voneinander beabstandet angeordnet sind. Eine Höhe bezeichnet eine Dimension, die in einer Vertikalrichtung gemessen wird, wobei die Vertikalrichtung senkrecht zur vorhergehend erläuterten Längsrichtung und zur vorhergehend erläuterten Querrichtung orientiert ist.

Simulationen haben ergeben, dass eine derartige Ausbildung und Anordnung der beiden Leiterstrukturen zueinander eine Reduktion oder Kompensation der bei Stromfluss auf die Leiterstrukturen wirkenden Stromkräfte ermöglicht. Insbesondere können Stromkräfte auf weniger als 25 % der Stromkräfte reduziert werden, die bei gleicher Stromstärke in einer Stromschienenanordnung wirken, wobei die beiden Leiterstrukturen als ebene Leiterplatten ausgebildet sind.

Ebenfalls ergibt sich hierdurch in vorteilhafter Weise eine einfache Ausbildung der Leiterstrukturen, was z.B. eine Fertigung der Leiterstrukturen vereinfacht. Ebenfalls haben Versuche ergeben, dass bei der vorgeschlagenen Ausbildung und Anordnung der beiden Leiterstrukturen eine geringe Induktivität der Stromschienenanordnung erreichbar ist.

In einer bevorzugten Ausführungsform ist der zumindest eine Abschnitt der seitlichen Leiterplatte der zweiten Leiterstruktur parallel zu den seitlichen Leiterplatten der ersten Leiterstruktur angeordnet.

Hierdurch ergibt sich in vorteilhafter Weise eine Verteilung der bei Stromfluss wirkenden Stromkräfte derart, dass eine größtmögliche Kompensation oder Reduktion ermöglicht wird.

In einer weiteren Ausführungsform ist der zumindest eine Abschnitt der seitlichen Leiterplatte der zweiten Leiterstruktur mittig zwischen den seitlichen Leiterplatten der ersten Leiterstruktur angeordnet.

Hierdurch ergibt sich in vorteilhafter Weise, dass eine erforderliche Luftstrecke und/oder Kriechstrecke zwischen den Leiterstrukturen in Bezug auf jeden Abschnitt der Leiterstrukturen eingehalten werden kann.

Insbesondere kann in den vorhergehend erläuterten Ausführungsformen gleichzeitig zumindest ein Abschnitt einer seitlichen Leiterplatte der ersten Leiterstruktur in ein Innenvolumen der zweiten Leiterstruktur hineinragen. Weiter kann auch dieser Abschnitt der ersten Leiterstruktur parallel zu den seitlichen Leiterplatten der zweiten Leiterstruktur angeordnet sein, insbesondere mittig zwischen den seitlichen Leiterplatten der zweiten Leiterstruktur angeordnet sein.

In einer weiteren Ausführungsform ist der mindestens eine Abstandshalter mechanisch mit der ersten Leiterstruktur und/oder mechanisch mit der zweiten Leiterstruktur verbunden.

Hierbei können der Abstandshalter und die entsprechende Leiterstruktur derart miteinander verbunden sein, dass die mechanische Verbindung eine vorbestimmte Kraft, insbesondere eine Zug- oder Druckkraft, aufnehmen kann, ohne dass eine Relativbewegung zwischen den Leiterstrukturen auftritt.

Der Abstandshalter und die entsprechende Leiterstruktur sind verschraubt. Die mechanische Verbindung kann insbesondere eine lösbare oder unlösbare mechanische Verbindung sein.

Vorzugsweise ist jedoch die entsprechende Leiterstruktur mit dem mindestens einen Abstandshalter verschraubt. Hierbei kann die Leiterstruktur z.B. im Bereich der seitlichen Leiterplatte oder im Bereich der Bodenleiterplatte eine Öffnung aufweisen. Der Abstandshalter kann hierbei ebenfalls eine Öffnung mit einem Innengewinde aufweisen. Der Abstandshalter kann derart relativ zu der entsprechenden Leiterstruktur angeordnet sein, dass die Öffnung in der Leiterstruktur mit der Öffnung mit dem Innengewinde fluchtet.

Auch ist es vorstellbar, dass eine Gewindehülse in einem Loch im Abstandshalter angeordnet wird, die das vorhergehend erläuterte Innengewinde aufweist. Hierdurch lässt sich in vorteilhafter Weise eine Stabilität der mechanischen Verbindung erhöhen.

Die mechanische Verbindung des mindestens einen Abstandshalters mit der oder den Leiterstruktur(en) ermöglicht in vorteilhafter Weise eine erhöhte mechanische Stabilität, falls Stromkräfte zwischen den Leiterstrukturen auftreten.

Weiter erfindungsgemäß weist der mindestens eine Abstandshalter mindestens ein Sackloch auf. Das Sackloch weist hierbei das vorhergehend erläuterte Innengewinde auf. Alternativ ist in dem Sackloch die vorhergehend erläuterte Gewindehülse mit dem Innengewinde angeordnet. Weiter schneidet eine zentrale Achse des Sackloches eine Leiterstruktur im Bereich einer Ausnehmung.

Hierdurch ergibt sich in vorteilhafter Weise eine aufgrund der Anordnung von Ausnehmung und Befestigungsöffnung gewährleisteter Minimalabstand der Schraube zu der Leiterstruktur, welche nicht durch die Schraube mit dem Abstandshalter mechanisch verbunden ist und somit nicht mechanisch und elektrisch kontaktiert werden soll.

Weiter vorgeschlagen wird ein Verfahren zur Herstellung einer Stromschienenanordnung, wobei das Verfahren folgende Verfahrensschritte umfasst:
- Bereitstellen einer ersten und einer zweiten wannenförmigen Leiterstruktur,
- Anordnen der ersten Leiterstruktur und der zweiten Leiterstruktur zueinander derart, dass zumindest ein Abschnitt der zweiten Leiterstruktur in einem Innenvolumen der ersten Leiterstruktur angeordnet ist.

Weiter wird mindestens ein Abstandhalter zwischen der ersten Leiterstruktur und der zweiten Leiterstruktur angeordnet.

Gleichzeitig kann das Anordnen der ersten Leiterstruktur und der zweiten Leiterstruktur zueinander derart erfolgen, dass zumindest ein Abschnitt der ersten Leiterstruktur in einem Innenvolumen der zweiten Leiterstruktur angeordnet ist.

Hierdurch ergibt sich in vorteilhafter Weise ein Verfahren zur Herstellung einer der vorhergehend erläuterten Stromschienenanordnungen.

Die Erfindung wird anhand eines Ausführungsbeispiels näher erläutert. Die Figuren zeigen:
- Fig. 1: eine perspektivische Ansicht einer erfindungsgemäßen Stromschienenanordnung,
- Fig. 2: einen Querschnitt durch die in Fig. 1 dargestellte Stromschienenanordnung,
- Fig. 3: einen weiteren Querschnitt durch die in Fig. 1 dargestellte Stromschienenanordnung,
- Fig. 4: eine perspektivische Detailansicht der in Fig. 1 dargestellten Stromschienenanordnung,
- Fig. 5: eine weitere perspektivische Ansicht der in Fig. 1 dargestellten Stromschienenanordnung,
- Fig. 6: einen weiteren Querschnitt durch die in Fig. 1 dargestellte Stromschienenanordnung und
- Fig. 7: einen Längsschnitt durch die in Fig. 1 dargestellte Stromschienenanordnung.

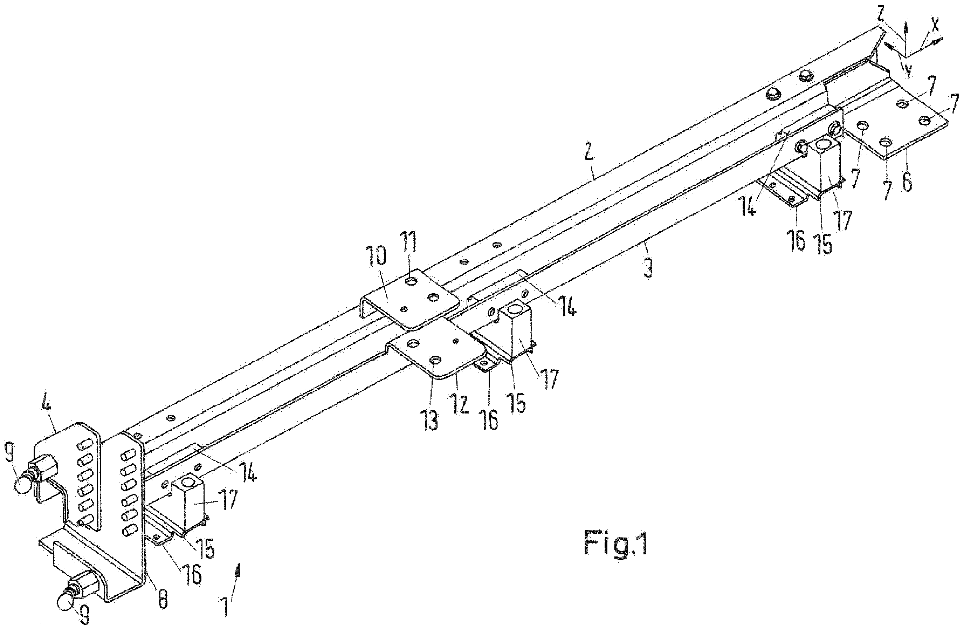

In Fig. 1 ist eine perspektivische Ansicht einer Stromschienenanordnung 1 dargestellt. Die Stromschienenanordnung 1 weist eine erste wannenförmig ausgebildete Leiterstruktur 2 auf. Weiter umfasst die Stromschienenanordnung 1 eine zweite, ebenfalls wannenförmig ausgebildete, Leiterstruktur 3.

Die Leiterstrukturen 2, 3 weisen in einem Querschnitt in einer Querschnittsebene senkrecht zu einer zentralen Längsachse der Stromschienenanordnung 1 einen U-förmigen Querschnitt auf. Hierbei erstreckt sich die zentrale Längsachse der Stromschienenanordnung 1 in eine Längsrichtung x.

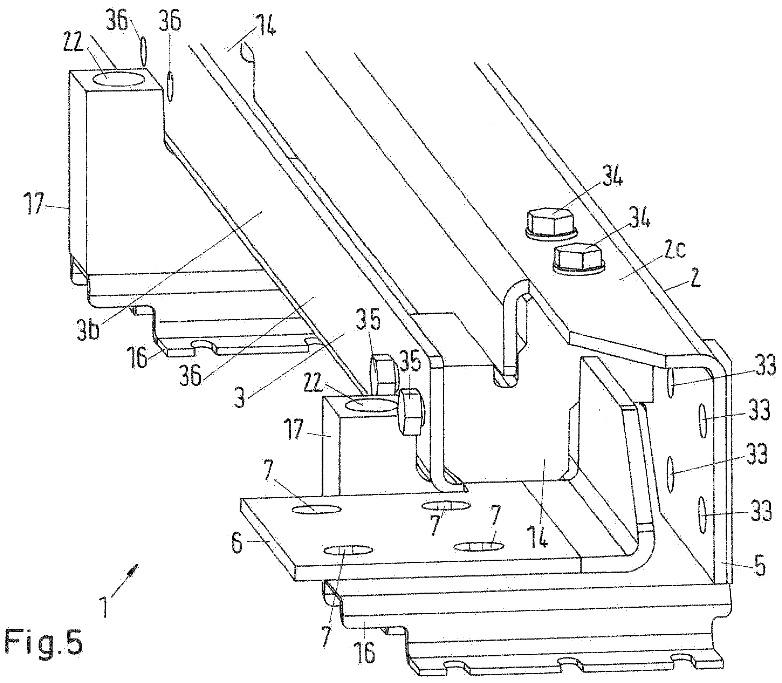

Die erste Leiterstruktur 2 kann hierbei auch als Plusschiene bezeichnet werden, die ein höheres Potential als die zweite Leiterstruktur 3, die auch als Minusschiene bezeichnet werden kann, bei einem bestimmungsmäßigen Gebrauch der Stromschienenanordnung 1 aufweist. Die erste Leiterstruktur 2 ist über eine eingangsseitige Anschlussplatte 4 kontaktierbar, die elektrisch mit der ersten Leiterstruktur 2 verbunden ist. Beispielsweise kann über die eingangsseitige Anschlussplatte 4 ein Netzstromrichter an die erste Leiterstruktur 2 elektrisch angeschlossen werden. Weiter weist die erste Leiterstruktur 2 eine ausgangsseitige Anschlussplatte 5 (siehe Fig. 5) auf. Über die ausgangsseitige Anschlussplatte 5 kann beispielsweise ein Motorstromrichter, insbesondere mindestens ein Leistungshalbleiterelement eines Motorstromrichters, beispielsweise ein Brückenzweig, der zwei MOSFET oder IGBT umfasst, an die erste Leiterstruktur 2 angeschlossen werden. Die zweite Leiterstruktur 3 weist eine eingangsseitige Anschlussplatte 6 auf. Hierbei ist dargestellt, dass die eingangsseitige Anschlussplatte 6 vier Öffnungen 7 aufweist, durch die die eingangsseitige Anschlussplatte 6 z.B. mit einer weiteren Leiterplatte (nicht dargestellt) mechanisch verbunden werden kann, wobei die weitere Leiterplatte einer Rückleitung von Strom von dem Motorstromrichter dient.

Weiter weist die zweite Leiterstruktur 3 eine ausgangsseitige Anschlussplatte 8 auf, über die wiederum der vorhergehend erläuterte Netzstromrichter an die zweite Leiterstruktur 3 angeschlossen werden kann. Dargestellt sind weiter Erdungspunkte 9, über die die Leiterstruktur 2, 3, z.B. vor einer Demontage, geerdet werden können. Hierzu können beispielsweise die Erdungspunkte 9 mit einem Erdpotential verbunden werden.

Weiter weist die erste Leiterstruktur 2 ein weiteres Anschlusselement 10 auf. Dieses ist in einem Querschnitt mit einer Querschnittsebene senkrecht zur Längsrichtung x L-förmig ausgebildet, wobei ein erster Schenkel des weiteren Anschlusselements in einer Vertikalrichtung z verläuft und ein zweiter Schenkel des weiteren Anschlusselements 10 in einer Querrichtung y verläuft. Auch das weitere Anschlusselement 10 weist Löcher 11 auf, über die das weitere Anschlusselement mechanisch mit z.B. einer kontaktierenden Leiterplatte verbunden werden kann. Auch die zweite Leiterstruktur 3 weist ein weiteres Anschlusselement 12 mit Löchern 13 auf. Auch dieses ist in einer Querschnittsebene senkrecht zur Längsrichtung x L-förmig ausgebildet. Hierbei sind die jeweils zweiten Schenkel der weiteren Anschlusselemente 11, 12 parallel und mit einem vorbestimmten Abstand in der Vertikalrichtung z zueinander angeordnet.

Diese weiteren Anschlusselemente 10, 12 dienen dem elektrischen Anschluss eines so genannten Saugkreises. Der Saugkreis bezeichnet einen auf die doppelte Netzfrequenz abgestimmten LC-Reihenschwingkreis.

Weiter dargestellt sind Abstandshalter 14, die zwischen der ersten und der zweiten Leiterstruktur 2, 3 angeordnet sind. Hierbei sind drei Abstandshalter 14 entlang der Längsrichtung x mit einem vorbestimmten Abstand voneinander angeordnet.

Weiter dargestellt sind Tragelemente 15, die jeweils ein Fußelement 16, welches beispielsweise aus Metall ausgebildet sein kann, und ein Isolationselement 17, welches z.B. aus Kunststoff, z.B. Polyesterharz, ausgebildet sein kann, umfassen.

Die Tragelemente 15 sind hierbei in Vertikalrichtung z unter der zweiten Leiterstruktur 3 angeordnet, wobei die Tragelemente 15 in Längsrichtung x im Bereich der Abstandshalter 14 angeordnet sind.

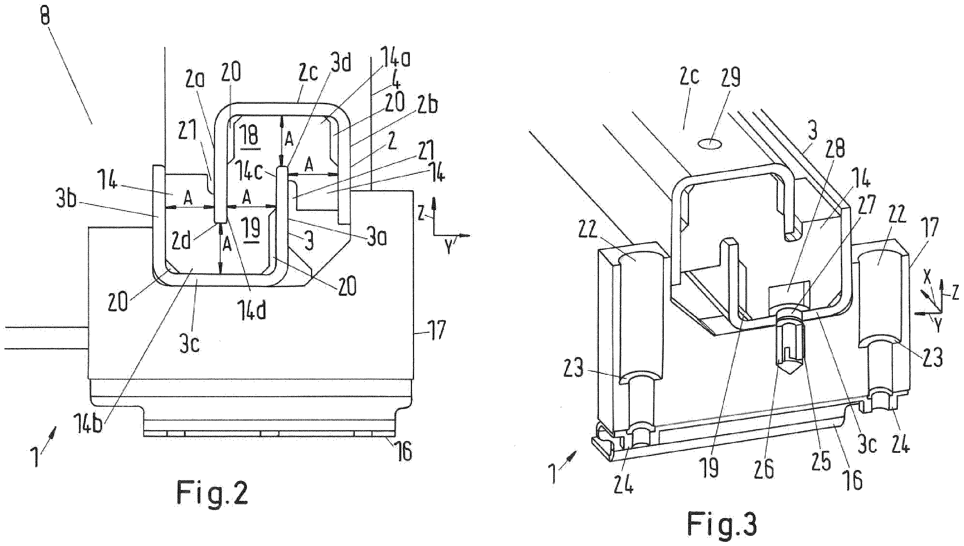

In Fig. 2 ist ein Querschnitt durch die in Fig. 1 dargestellte Stromschienenanordnung 1 im Bereich eines Abstandshalters 14 dargestellt. Hierbei ist ersichtlich, dass die erste Leiterstruktur 2 und die zweite Leiterstruktur 3 jeweils ein U-förmiges Profil aufweisen. Hierbei umfasst die erste Leiterstruktur 2 eine erste seitliche Leiterplatte 2a, eine zweite seitliche Leiterplatte 2b und eine Bodenleiterplatte 2c. Die seitlichen Leiterplatten 2a, 2b sind parallel zueinander angeordnet, wobei die seitlichen Leiterplatten 2a, 2b senkrecht zur Bodenleiterplatte 2c angeordnet sind. Hierbei sind von den seitlichen Leiterplatten 2a, 2b und der Bodenleiterplatte 2c gebildete Ecken abgerundet. Entsprechend umfasst die zweite Leiterstruktur 3 eine erste seitliche Leiterplatte 3a, eine zweite seitliche Leiterplatte 3b und eine Bodenleiterplatte 3c.

Die seitlichen Leiterplatten 2a, 2b und die Bodenleiterplatte 2c der ersten Leiterstruktur 2 umfassen ein Innenvolumen 18. Die seitlichen Leiterplatten 3a, 3b und die Bodenleiterplatte 3c der zweiten Leiterstruktur 3 umfassen ein Innenvolumen 19.

Hierbei sind die Leiterstrukturen 2, 3 derart zueinander angeordnet, dass die erste seitliche Leiterplatte 2a in das Innenvolumen 19 der zweiten Leiterstruktur 3 hineinragt. Gleichfalls ragt die erste seitliche Leiterplatte 3a der zweiten Leiterstruktur 3 in das Innenvolumen 18 der ersten Leiterstruktur 2 hinein. Die seitlichen Leiterplatten 2a, 3a sind hierbei parallel zueinander angeordnet und jeweils mittig zwischen den seitlichen Leiterplatten 3a, 3b, 2a, 2b der jeweils anderen Leiterstruktur 2, 3 angeordnet.

In Fig. 2 ist dargestellt, dass ein Abstand A zwischen den parallel zueinander angeordneten seitlichen Leiterplatten 2a, 2b, 3a, 3b jeweils gleich ist. Der vorbestimmte Abstand kann größer als oder gleich einer vorbestimmten Mindestluftstrecke und/oder einer vorbestimmten Mindestkriechstrecke sein. Mit diesem Abstand A sind ebenfalls Stirnflächen 2d, 3d der ersten seitlichen Leiterplatten 2a, 3a von den jeweils gegenüberliegenden Bodenleiterplatten 3c, 2c beabstandet.

Somit sind die ersten seitlichen Leiterplatten 2a, 3a derart in den entsprechenden Innenvolumina 19, 18 angeordnet, dass zu jeder Seite der vorbestimmte Abstand A zur jeweils anderen Leiterstruktur 2, 3 eingehalten wird.

In Fig. 2 ist weiter der Abstandshalter 14 dargestellt. Dieser Abstandshalter 14 umfasst einen ersten Teil 14a, der im Innenvolumen 18 der ersten Leiterstruktur 2 angeordnet ist.

Weiter umfasst der Abstandshalter 14 einen zweiten Teil 14b, der in dem Innenvolumen 19 der zweiten Leiterstruktur 3 angeordnet ist. Jedoch ist der Abstandshalter 14 einstückig ausgebildet. Es ist ersichtlich, dass der Abstandshalter 14 einen im Wesentlichen S-förmigen Querschnitt aufweist. Der erste Teil 14a des Abstandshalters 14 weist eine zentrale Nut 14c auf, die in Bezug auf die Vertikalrichtung z nach unten geöffnet ist. In diese zentrale Nut 14c ragt ein freies Ende der ersten seitlichen Leiterplatte 3a der zweiten Leiterstruktur 3.

Dementsprechend weist der zweite Teil 14b des Abstandshalters 14 eine zentrale Nut 14d auf. Diese ist in Vertikalrichtung z nach oben geöffnet. Weiter ragt ein freies Ende der ersten seitlichen Leiterplatte 2a der ersten Leiterstruktur 2 in diese zentrale Nut 14d hinein.

Hierbei ist der Abstandshalter 14 derart ausgebildet, dass sich im Bereich der Ecken der ersten und der zweiten Leiterstruktur 2, 3 Freiräume 20 ergeben, wenn der Abstandshalter 14 in den Innenvolumina 18, 19 angeordnet ist.

Weiter dargestellt ist, dass der Abstandshalter 14 in einem Bereich des Innenvolumens 18 der ersten Leiterstruktur 2, welcher zwischen der ersten seitlichen Leiterplatte 3a der zweiten Leiterstruktur 3 und der zweiten seitlichen Leiterplatte 2b der zweiten Leiterstruktur angeordnet ist, einen Freiraum 21 ausbildet. Ebenso bildet der Abstandshalter 14 in einem Bereich des Innenvolumens 19, der zwischen der ersten seitlichen Leiterplatte 2a der ersten Leiterstruktur 2 und der zweiten seitlichen Leiterplatte 3b der zweiten Leiterstruktur 3 angeordnet ist, einen Freiraum 21 aus. Diese Freiräume 21 entstehen, da die Nuten 14c, 14d in Querrichtung y breiter ausgebildet sind als eine Breite der seitlichen Leiterplatten 2a, 3a. Hierdurch werden die seitlichen Leiterplatten 2a, 3a nicht in den Nuten 14c, 14d geklemmt. Dies dient einer Kompensation von Fertigungstoleranzen.

In Fig. 3 ist ein weiterer Querschnitt durch die in Fig. 1 dargestellte Stromschienenanordnung 1 dargestellt. Im Unterschied zu Fig. 2 ist dargestellt, dass das Isolationselement 17 seitliche Öffnungen 22 aufweist, die in Vertikalrichtung z nach oben hin geöffnet sind. Durch diese seitlichen Öffnungen 22 können z.B. Befestigungsschrauben in das Isolationselement 17 eingebracht werden, wobei ein Schraubenkopf der nicht dargestellten Befestigungsschrauben auf Auflageflächen 23 aufliegen können. Das Bodenelement 16 weist in dem Bodenelement 16 angeordnete Muttern 24 auf. Somit kann das Isolationselement 17 durch die Öffnungen 22 mit dem Bodenelement 16 verschraubt werden. Weiter dargestellt ist ein zentrales Sackloch 25 im Isolationselement 17. In diesem zentralen Sackloch 25 ist eine Gewindehülse 26 angeordnet, die ein Innen- und ein Außengewinde aufweist. Über das Außengewinde ist die Gewindehülse 26 in das Isolationselement 17 eingeschraubt. Das Innengewinde der Gewindehülse 26 dient zum Verschrauben der zweiten Leiterstruktur 3 mit dem Isolationselement 17. Hierzu weist die Bodenleiterplatte 3c der zweiten Leiterstruktur 3 eine Öffnung 27 auf, wobei ein Durchmesser dieser Öffnung 27 größer als ein Durchmesser der Gewindehülse 26 ist. Der Abstandshalter 14 weist ebenfalls ein Sackloch 28 auf, in welchem ein Schraubenkopf einer nicht dargestellten Befestigungsschraube zur mechanischen Verbindung der zweiten Leiterstruktur 3 mit dem Isolationselement 17 angeordnet werden kann. Das Sackloch 27 ist hierbei im Innenvolumen 19 (siehe Fig. 2) der zweiten Leiterstruktur 3 angeordnet.

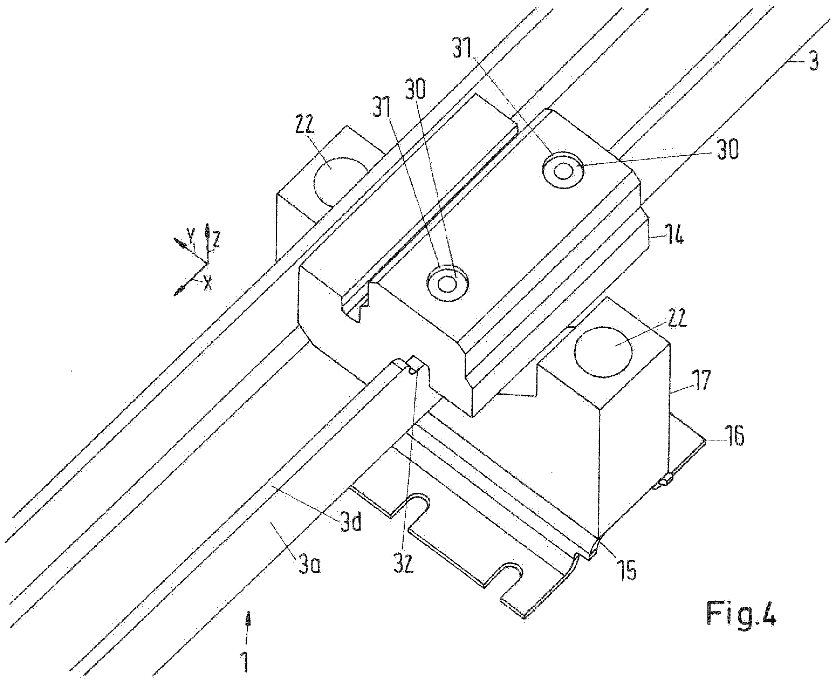

Ebenfalls in Fig. 3 dargestellt ist eine Öffnung 29 in der Bodenleiterplatte 2c der ersten Leiterstruktur 2. Durch diese Öffnung 29 kann, wie nachfolgend näher erläutert, eine Schraube 34 (siehe Fig. 5) in eine Gewindehülse 30, die in einem Sackloch 31 (siehe z.B. Fig. 4) des Abstandshalters 14 angeordnet ist, eingebracht werden. Hierdurch kann die erste Leiterstruktur 2 mit dem Abstandshalter 14 mechanisch verbunden, insbesondere verschraubt werden.

In Fig. 4 ist eine perspektivische Detailansicht der Stromschienenanordnung aus Fig. 1 dargestellt. Hierbei ist ausschließlich die zweite Leiterstruktur 3 und ein Abstandshalter 14 sowie ein Tragelement 15 dargestellt. Hierbei ist dargestellt, dass der Abstandshalter 14 Sacklöcher 31 aufweist, in welche Gewindehülsen 30 eingebracht sind. Die Gewindehülsen 30 weisen, ebenso wie die Gewindehülse 25, jeweils ein Innen- und ein Außengewinde auf, wobei eine Gewindehülse 30 über das Außengewinde in den Abstandshalter 14 eingeschraubt ist. Die Sacklöcher 31 sind, wenn der Abstandshalter 14 in dem Innenvolumen 18 der ersten Leiterstruktur 2 angeordnet ist, hin zur bodenseitigen Leiterplatte 2c der ersten Leiterstruktur 2, also in Vertikalrichtung z nach oben, geöffnet. Durch Löcher 29 in der bodenseitigen Leiterplatte 2c (siehe Fig. 3) kann eine Schraube 34 (siehe Fig. 5) in die Gewindehülse 30 eingebracht und über das Innengewinde mit dem Abstandshalter 14 verschraubt werden.

Hierbei ist ersichtlich, dass die erste seitliche Leiterplatte 3a der zweiten Leiterstruktur 3 im Bereich des Abstandshalters 14 eine Ausnehmung 32 aufweist. Die Ausnehmung 32 wird hierbei durch eine Vertiefung in Vertikalrichtung z der Stirnfläche 3d der ersten seitlichen Leiterplatte 3a gebildet. Hierdurch wird in vorteilhafter Weise gewährleistet, dass Schrauben 34 zur Befestigung der ersten Leiterstruktur 2 (siehe z.B. Fig. 5) eine Länge aufweisen können, die zum Bereitstellen einer vorbestimmten Verbindungskraft oder Verbindungsfestigkeit notwendig ist, ohne dass die Schraube 34 einen mechanischen oder elektrischen Kontakt zwischen der ersten Leiterstruktur 2 und der zweiten Leiterstruktur 3, insbesondere der Stirnfläche 3d der zweiten Leiterstruktur 3, herstellt.

In Fig. 5 ist eine weitere perspektivische Ansicht der in Fig. 1 dargestellten Stromschienenanordnung 1 dargestellt. Hierbei ist insbesondere auch die vorhergehend erläuterte ausgangsseitige Anschlussplatte 5 der ersten Leiterstruktur 2 dargestellt. Diese weist ebenfalls vier Befestigungslöcher 33 auf, mittels derer beispielsweise eine weitere Leiterplatte zur elektrischen Kontaktierung der ersten Leiterstruktur 2 an diese angeschraubt werden kann. Ebenfalls dargestellt sind Schrauben 34, über die die erste Leiterstruktur 2, insbesondere die Bodenleiterplatte 2c der ersten Leiterstruktur 2, mit einem Abstandshalter 14 mechanisch verbunden ist. Hierbei greift ein nicht dargestellter Gewindeabschnitt der Sechskantschrauben 34 in die in Fig. 5 dargestellten Innengewinde der Gewindehülsen 30 ein.

Ebenfalls dargestellt sind weitere Befestigungsschrauben 35, die die zweite Leiterstruktur 3, insbesondere die zweite seitliche Leiterplatte 3b, mit dem Abstandshalter 14 mechanisch verbinden. Diese Schrauben 35 erstrecken sich durch Löcher 36 in der zweiten seitlichen Leiterplatte 3b der zweiten Leiterstruktur 3.

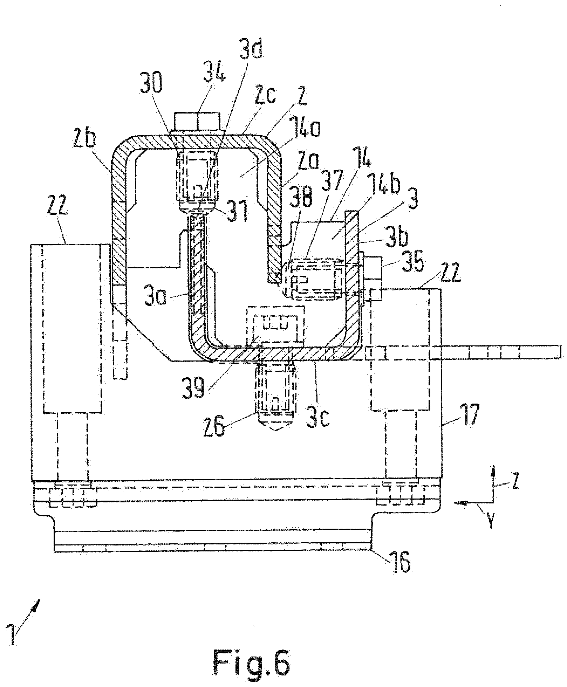

In Fig. 6 ist ein weiterer Querschnitt durch die Stromschienenanordnung 1, die auch in Fig. 1 dargestellt ist, gezeigt. Hierbei sind insbesondere die Befestigungsschrauben 34, 35 dargestellt, durch die die Leiterstrukturen 2, 3 jeweils mit dem Abstandshalter 14 verbunden sind. Hierbei ist die Gewindehülse 30 dargestellt, die in einem Sackloch 31 des Abstandshalters 14, insbesondere in dem ersten Teil 14a des Abstandshalters 14, angeordnet ist. Hierbei ist eine zentrale Symmetrieachse des Sackloches 31 parallel zur Vertikalrichtung z. Ein Außengewinde der Schraube 34 ist mit einem Innengewinde der Gewindehülse 30 verschraubt. Dargestellt ist weiter, dass ein bodenseitiges Ende des Sackloches 31 in Vertikalrichtung z unterhalb einer Stirnfläche 3d der ersten seitlichen Leiterplatte 3a der zweiten Leiterstruktur 3 angeordnet ist. Um, wie vorhergehend erläutert, den mechanischen und elektrischen Kontakt zwischen der Befestigungsschraube 34 und der zweiten Leiterstruktur 3 in diesem Bereich zu verhindern, weist die seitliche Leiterplatte 3a der zweiten Leiterstruktur 3 in diesem Bereich die in Fig. 4 dargestellte Vertiefung oder Ausnehmung 32 in Vertikalrichtung z auf.

Dargestellt ist weiter, dass die Befestigungsschraube 35 sich in eine Gewindehülse 37 erstreckt, die in einem Sackloch 38 des Abstandshalter 14, insbesondere des zweiten Teils 14b des Abstandshalters 14, angeordnet ist.

Das Sackloch 38 ist, wenn der Abstandshalter 14 in dem Innenvolumen 19 der zweiten Leiterstruktur 3 angeordnet ist, hin zur zweiten seitlichen Leiterplatte 3b der zweiten Leiterstruktur 3 geöffnet. Hierbei ist eine zentrale Symmetrieachse des Sackloches 38 parallel zu einer Querrichtung y. Weiter dargestellt ist eine Befestigungsschraube 39, die in eine Gewindehülse 26 eingreift, wodurch, wie in Bezug auf Fig. 3 erläutert, die Bodenleiterplatte 3c der zweiten Leiterstruktur 3 mechanisch mit dem Isolationselement 17 verbunden ist.

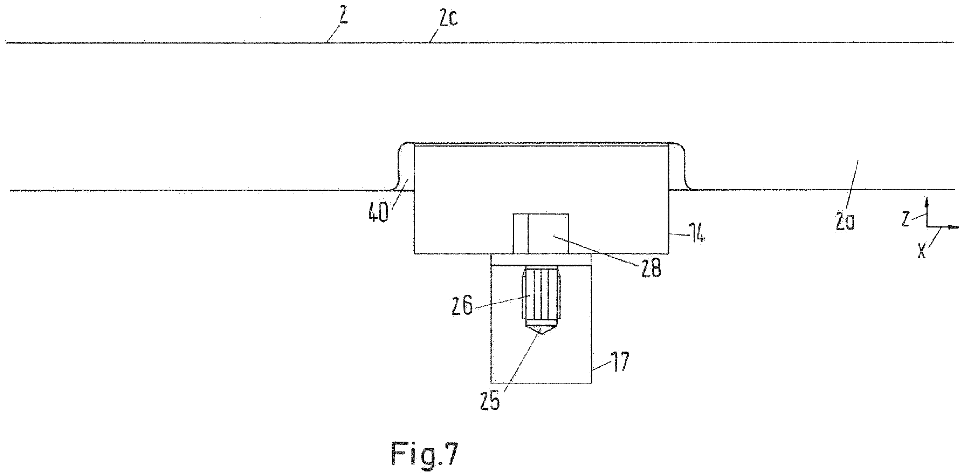

Dargestellt ist weiter, dass ein bodenseitiges Ende des Sackloches 38 in Querrichtung y oberhalb einer Oberfläche der ersten seitlichen Leiterplatte 2a der ersten Leiterstruktur 2 angeordnet ist. Um, wie vorhergehend erläutert, den mechanischen und elektrischen Kontakt zwischen der Befestigungsschraube 35 und der ersten Leiterstruktur 2 in diesem Bereich zu verhindern, weist die erste seitliche Leiterplatte 2a der ersten Leiterstruktur 2 in diesem Bereich eine Vertiefung oder Ausnehmung 40 in Querrichtung y auf (siehe Fig. 7).

Eine solche Ausnehmung 40 in der ersten seitlichen Leiterplatte 2a der ersten Leiterstruktur 2 ist in Fig. 7 dargestellt, wobei in Fig. 7 ein Längsschnitt der in Fig. 1 dargestellten Stromschienenanordnung 1 dargestellt ist. Hierbei ist insbesondere dargestellt, dass die Ausnehmung 40 ausschnittartig ausgebildet ist und in Längsrichtung x eine Länge aufweist, die größer als eine Länge des Abstandshalters 14 in Längsrichtung x ist. Eine Tiefe der Ausnehmung 40 in Querrichtung y, die in Fig. 7 in die Zeichenebene hineinzeigt, kann in Abhängigkeit eines gewünschten Mindestabstands zwischen einem Ende der Schraube 35 (siehe z.B. Fig. 6) und der ersten seitlichen Leiterplatte 2a der ersten Leiterstruktur 2 gewählt werden.

Auch die erste seitliche Leiterplatte 3a der zweiten Leiterstruktur 3 kann eine entsprechende Vertiefung entgegen der Querrichtung y aufweisen. Auch kann die zweite seitliche Leiterplatte 2b der ersten Leiterstruktur Öffnungen aufweisen, durch die eine Schraube in ein Innengewinde im ersten Teil 14a des Abstandshalters 14 eingebracht werden kann. Die Vertiefung der ersten seitlichen Leiterplatte 3a der zweiten Leiterstruktur 3 kann im Bereich des Abstandshalters 14 angeordnet sein. Somit kann die erste Leiterstruktur 2 mit dem Abstandshalter 14 mit einer vorbestimmten Befestigungskraft mechanisch verbunden werden, wobei ein mechanischer und elektrischer Kontakt zwischen einer Schraube und der zweiten Leiterstruktur 3 vermieden wird.

## Patentansprüche

1. Stromschienenanordnung, wobei die Stromschienenanordnung (1) eine erste Leiterstruktur (2) und eine zweite Leiterstruktur (3) umfasst, wobei die erste Leiterstruktur (2) und die zweite Leiterstruktur (3) nicht unmittelbar elektrisch verbunden sind, wobei die erste Leiterstruktur (2) wannenförmig ausgebildet ist, wobei die zweite Leiterstruktur (3) wannenförmig ausgebildet ist, wobei zumindest ein Abschnitt der zweiten Leiterstruktur (3) in einem Innenvolumen (18) der ersten Leiterstruktur (2) angeordnet ist, wobei
zwischen der ersten Leiterstruktur (2) und der zweiten Leiterstruktur (3) mindestens ein Abstandshalter (14) angeordnet ist,
**dadurch gekennzeichnet, dass**
die erste Leiterstruktur (2) mit dem Abstandshalter (14) mit einer Befestigungsschraube (34, 35) verschraubt ist und die zweite Leiterstruktur (3) im Bereich des mindestens einen Abstandshalters (14) zumindest eine Ausnehmung (32, 40) aufweist oder die zweite Leiterstruktur (3) mit dem Abstandshalter (14) mit einer Befestigungsschraube (34, 35) verschraubt ist und die erste Leiterstruktur (2) im Bereich des mindestens einen Abstandshalters (14) zumindest eine Ausnehmung (32, 40) aufweist, wobei der mindestens eine Abstandshalter (14) mindestens ein Sackloch (30, 38) aufweist, wobei das Sackloch (30, 38) ein Innengewinde zur Einbringung der Befestigungsschraube (34, 35) aufweist oder wobei in dem Sackloch (30, 38) eine Gewindehülse mit einem Innengewinde zur Einbringung der Befestigungsschraube (34, 35) angeordnet ist, wobei eine zentrale Achse des Sackloches (30, 38) die Leiterstruktur (2, 3) im Bereich der Ausnehmung (32, 40) schneidet.

2. Stromschienenanordnung nach Anspruch 1, **dadurch gekennzeichnet, dass** die erste Leiterstruktur (2) zwei parallel und mit einem vorbestimmten Abstand zueinander angeordnete seitliche Leiterplatten (2a, 2b) und eine Bodenleiterplatte (2c) umfasst, wobei die seitlichen Leiterplatten (2a, 2b) senkrecht zur Bodenleiterplatte (2c) angeordnet sind, wobei die zweite Leiterstruktur (3) zwei parallel und mit einem vorbestimmten Abstand zueinander angeordnete seitliche Leiterplatten (3a, 3b) und eine Bodenleiterplatte (3c) umfasst, wobei die seitlichen Leiterplatten (3a, 3b) senkrecht zur Bodenleiterplatte (3c) angeordnet sind, wobei zumindest ein Abschnitt einer seitlichen Leiterplatte (3a) der zweiten Leiterstruktur (3) in dem Innenvolumen (18) der ersten Leiterstruktur (2) angeordnet ist.

3. Stromschienenanordnung nach Anspruch 2, **dadurch gekennzeichnet, dass** der zumindest eine Abschnitt der seitlichen Leiterplatte (3a) der zweiten Leiterstruktur (3) parallel zu den seitlichen Leiterplatten (2a, 2b) der ersten Leiterstruktur (2) angeordnet ist.

4. Stromschienenanordnung nach Anspruch 2 oder 3, **dadurch gekennzeichnet, dass** der zumindest eine Abschnitt der seitlichen Leiterplatte (3a) der zweiten Leiterstruktur (3) mittig zwischen den seitlichen Leiterplatten (2a, 2b) der ersten Leiterstruktur (2) angeordnet ist.

5. Stromschienenanordnung nach einem der Ansprüche 1 bis 4, **dadurch gekennzeichnet, dass** der mindestens eine Abstandshalter (14) mechanisch mit der ersten Leiterstruktur (2) und/oder mechanisch mit der zweiten Leiterstruktur (3) verbunden ist.

6. Verfahren zur Herstellung einer Stromschienenanordnung, umfassend folgende Verfahrensschritte:
- Bereitstellen einer ersten und einer zweiten wannenförmigen Leiterstruktur (2, 3),
- Anordnen der ersten Leiterstruktur (2) und der zweiten Leiterstruktur (3) zueinander derart, dass zumindest ein Abschnitt der zweiten Leiterstruktur (3) in einem Innenvolumen (18) der ersten Leiterstruktur (2) angeordnet ist,
- Anordnen mindestens eines Abstandhalters (14) zwischen der ersten Leiterstruktur (2) und der zweiten Leiterstruktur (3), wobei die erste Leiterstruktur (2) mit dem Abstandshalter (14) mit einer Befestigungsschraube (34, 35) verschraubt ist und die zweite Leiterstruktur (3) im Bereich des mindestens einen Abstandshalters (14) zumindest eine Ausnehmung (32, 40) aufweist oder die zweite Leiterstruktur (3) mit dem Abstandshalter (14) mit einer Befestigungsschraube (34, 35) verschraubt ist und die erste Leiterstruktur (2) im Bereich des mindestens einen Abstandshalters (14) zumindest eine Ausnehmung (32, 40) aufweist, wobei der mindestens eine Abstandshalter (14) mindestens ein Sackloch (30, 38) aufweist, wobei das Sackloch (30, 38) ein Innengewinde zur Einbringung der Befestigungsschraube (34, 35) aufweist oder wobei in dem Sackloch (30, 38) eine Gewindehülse mit einem Innengewinde zur Einbringung der Befestigungsschraube (34, 35) angeordnet ist, wobei eine zentrale Achse des Sackloches (30, 38) die Leiterstruktur (2, 3) im Bereich der Ausnehmung (32, 40) schneidet..

## Claims

1. A busbar arrangement, wherein the busbar arrangement (1) comprises a first conductor structure (2) and a second conductor structure (3), wherein the first conductor structure (2) and the second conductor structure (3) are not electrically connected in a direct manner, wherein the first conductor structure (2) is trough-shaped, wherein the second conductor structure (3) is trough-shaped, wherein at least one portion of the second conductor structure (3) is arranged in an internal volume (18) of the first conductor structure (2), and wherein
at least one spacer (14) is situated between the first conductor structure (2) and the second conductor structure (3),
**characterised in that**
the first conductor structure (2) is screwed to the spacer (14) by means of a fastening screw (34, 35) and the second conductor structure (3), in the region of the at least one spacer (14), has at least one recess (32, 40), or the second conductor structure (3) is screwed to the spacer (14) by means of a fastening screw (34, 35) and the first conductor structure (2), in the region of the at least one spacer (14), has at least one recess (32, 40), the at least one spacer (14) having at least one blind bore (30, 38), the blind bore (30, 38) having an inner thread for introducing the fastening screw (34, 35), or a threaded sleeve with an inner thread for introducing the fastening screw (34, 35) being situated in the blind bore (30, 38), a central axis of the blind bore (30, 38) intersecting the conductor structure (2, 3) in the region of the recess (32, 40).

2. The busbar arrangement according to claim 1, **characterised in that** the first conductor structure (2) comprises two parallel lateral conductor plates (2a, 2b) situated at a predetermined distance from one another and a bottom conductor plate (2c), the lateral conductor plates (2a, 2b) being situated perpendicularly to the bottom conductor plate (2c), the second conductor structure (3) comprising two parallel lateral conductor plates (3a, 3b) situated at a predetermined distance from one another and a bottom conductor plate (3c), the lateral conductor plates (3a, 3b) being situated perpendicularly to the bottom conductor plate (3c), at least one portion of a lateral conductor plate (3a) of the second conductor structure (3) being situated in the internal volume (18) of the first conductor structure (2).

3. The busbar arrangement according to claim 2, **characterised in that** the at least one portion of the lateral conductor plate (3a) of the second conductor structure (3) is situated parallel to the lateral conductor plates (2a, 2b) of the first conductor structure (2).

4. The busbar arrangement according to claim 2 or 3, **characterised in that** the at least one portion of the lateral conductor plate (3a) of the second conductor structure (3) is situated centrally between the lateral conductor plates (2a, 2b) of the first conductor structure (2).

5. The busbar arrangement according to any one of claims 1 to 4, **characterised in that** the at least one spacer (14) is connected mechanically to the first conductor structure (2) and/or mechanically to the second conductor structure (3).

6. A method for producing a busbar arrangement, comprising the following method steps:
- providing a first and a second trough-shaped conductor structure (2, 3),
- arranging the first conductor structure (2) and the second conductor structure (3) relative to one another in such a way that at least one portion of the second conductor structure (2) is situated in an internal volume (18) of the first conductor structure (2),
- arranging at least one spacer (14) between the first conductor structure (2) and the second conductor structure (3), the first conductor structure (2) being screwed to the spacer (14) by means of a fastening screw (34, 35), and the second conductor structure (3) having, in the region of the at least one spacer (14), at least one recess (32, 40), or the second conductor structure (3) being screwed to the spacer (14) by means of a fastening screw (34, 35), and the first conductor structure (2) having, in the region of the at least one spacer (14), at least one recess (32, 40), the at least one spacer (14) having at least one blind bore (30, 38), the blind bore (30, 38) having an inner thread for introducing the fastening screw (34, 35), or a threaded sleeve with an inner thread for introducing the fastening screw (34, 35) being situated in the blind bore (30, 38), a central axis of the blind bore (30, 38) intersecting the conductor structure (2, 3) in the region of the recess (32, 40).

## Revendications

1. Ensemble rail conducteur, dans lequel l'ensemble rail conducteur (1) comporte une première structure conductrice (2) et une seconde structure conductrice (3), dans lequel la première structure conductrice (2) et la seconde structure conductrice (3) ne sont pas en liaison électrique directe, dans lequel la première structure conductrice (2) est conçue en forme de cuve, dans lequel la seconde structure conductrice (3) est conçue en forme de cuve, dans lequel au moins un secteur de la seconde structure conductrice (3) est disposé dans un volume interne (18) de la première structure conductrice (2), dans lequel entre la première structure conductrice (2) et la seconde structure conductrice (3) est disposée au moins une entretoise (14),
**caractérisé en ce que**
la première structure conductrice (2) est vissée avec l'entretoise (14) avec une vis de fixation (34, 35) et la seconde structure conductrice (3) comprend dans la zone de l'au moins une entretoise (14) au moins un évidement (32, 40), ou la seconde structure conductrice (3) est vissée avec l'entretoise (14) avec une vis de fixation (34, 35) et la première structure conductrice (2) comprend dans la zone de l'au moins une entretoise (14) au moins un évidement (32, 40), dans lequel l'au moins une entretoise (14) comprend au moins un trou borgne (30, 38), dans lequel le trou borgne (30, 38) comprend un filet de vis interne pour la pose de la vis de fixation (34, 35) ou dans lequel, dans le trou borgne (30, 38) est disposée une douille taraudée avec un filet de vis interne pour la pose de la vis de fixation (34, 35), dans lequel un axe central du trou borgne (30, 38) coupe la structure conductrice (2, 3) dans la zone de l'évidement (32, 40).

2. Ensemble rail conducteur selon la revendication 1, **caractérisé en ce que** la première structure conductrice (2) comporte deux cartes de circuit imprimé latérales (2a, 2b) disposées parallèlement l'une à l'autre et à une distance prédéfinie l'une de l'autre, et une carte de circuit imprimé de fond (2c), dans lequel les cartes de circuit imprimé latérales (2a, 2b) sont disposées perpendiculairement à la carte de circuit imprimé de fond (2c), dans lequel la seconde structure conductrice (3) comporte deux cartes de circuit imprimé latérales (3a, 3b) disposées parallèlement l'une à l'autre et à une distance prédéfinie l'une de l'autre, et une carte de circuit imprimé de fond (3c), dans lequel les cartes de circuit imprimé latérales (3a, 3b) sont disposées perpendiculairement à la carte de circuit imprimé de fond (3c), dans lequel au moins un secteur d'une carte de circuit imprimé latérale (3a) de la seconde structure conductrice (3) est disposé dans le volume interne (18) de la première structure conductrice (2).

3. Ensemble rail conducteur selon la revendication 2, **caractérisé en ce que** l'au moins un secteur de la carte de circuit imprimé latérale (3a) de la seconde structure conductrice (3) est disposé parallèlement aux cartes de circuit imprimé latérales (2a, 2b) de la première structure conductrice (2).

4. Ensemble rail conducteur selon la revendication 2 ou 3, **caractérisé en ce que** l'au moins un secteur de la carte de circuit imprimé latérale (3a) de la seconde structure conductrice (3) est disposé au centre entre les cartes de circuit imprimé latérales (2a, 2b) de la première structure conductrice (2).

5. Ensemble rail conducteur selon l'une quelconque des revendications 1 à 4, **caractérisé en ce que** l'au moins une entretoise (14) est en liaison mécanique avec la première structure conductrice (2) et/ou en liaison mécanique avec la seconde structure conductrice (3).

6. Procédé de fabrication d'un ensemble rail conducteur, comportant les étapes de procédé suivantes :
- l'utilisation d'une première et d'une seconde structure conductrice en forme de cuve (2, 3),
- la disposition de la première structure conductrice (2) et de la seconde structure conductrice (3) l'une par rapport à l'autre de manière qu'au moins un secteur de la seconde structure conductrice (3) est disposé dans un volume interne (18) de la première structure conductrice (2),
- la disposition d'au moins une entretoise (14) entre la première structure conductrice (2) et la seconde structure conductrice (3), dans lequel la première structure conductrice (2) est vissée avec l'entretoise (14) avec une vis de fixation (34, 35) et la seconde structure conductrice (3) comprend dans la zone de l'au moins une entretoise (14) au moins un évidement (32, 40), ou la seconde structure conductrice (3) est vissée avec l'entretoise (14) avec une vis de fixation (34, 35) et la première structure conductrice (2) comprend dans la zone de l'au moins une entretoise (14) au moins un évidement (32, 40), dans lequel l'au moins une entretoise (14) comprend au moins un trou borgne (30, 38), dans lequel le trou borgne (30, 38) comprend un filet de vis interne pour la pose de la vis de fixation (34, 35) ou dans lequel, dans le trou borgne (30, 38) est disposée une douille taraudée avec un filet de vis interne pour la pose de la vis de fixation (34, 35), dans lequel un axe central du trou borgne (30, 38) coupe la structure conductrice (2, 3) dans la zone de l'évidement (32, 40).
